# EUROPÄISCHE PATENTSCHRIFT

(11) **EP 2 547 486 B1**
(45) Veröffentlichungstag und Bekanntmachung des Hinweises auf die Patenterteilung: **02.03.2016**
(21) Anmeldenummer: 11718274.1
(22) Anmeldetag: 12.04.2011
(51) Int. Cl.: B23K 26/06, B23K 26/08, B23K 26/00, G03F 7/20

(54) **VERFAHREN UND VORRICHTUNG ZUR RÄUMLICH PERIODISCHEN MODIFIKATION EINER SUBSTRATOBERFLÄCHE UNTER VERWENDUNG EINER TELEZENTRISCHEN F-THETA-OPTIK**
METHOD OF AND DEVICE FOR THE SPATIALLY PERIODIC MODIFICATION OF A SUBSTRATE SURFACE USING A TELECENTRIC F-THETA LENS
PROCÉDÉ ET DISPOSITIF DE MODIFICATION PÉRIODIQUE SPATIALE D'UNE SURFACE DE SUBSTRAT À L'AIDE D'UNE OPTIQUE F-THETA TELECENTRIQUE

(30) Priorität: 26.05.2010 DE 102010029321; 16.04.2010 DE 102010015351
(43) Veröffentlichungstag der Anmeldung: 23.01.2013
(73) Patentinhaber: Laser-Laboratorium Göttingen E.V., 37077 Göttingen (DE)
(72) Erfinder: SIMON, Peter, 37120 Bovenden (DE); KLEIN-WIELE, Jan-Hendrik, 37085 Göttingen (DE)
(74) Vertreter: Schneider, Peter Christian
(86) Internationale Anmeldenummer: PCT/EP2011/001820
(87) Internationale Veröffentlichungsnummer: WO 2011/128063

(56) Entgegenhaltungen:
- DE-A1-102006 032 053
- JP-A- 2005 066 628
- US-A1- 2007 138 151

## Beschreibung

Die Erfindung bezieht sich auf ein Verfahren zur wenigstens bereichsweise räumlich periodischen Modifikation einer in einer Probenebene angeordneten Oberfläche eines Substrates, indem unterschiedliche Bereiche der Substratoberfläche nacheinander jeweils mit einem räumlich periodischen Beleuchtungsmuster einer Energiedichte oberhalb einer Prozessschwelle der Substratoberfläche beaufschlagt werden, wobei das Beleuchtungsmuster mittels Beugung eines Eingangsstrahls und Überlagerung resultierender, gebeugter Teilstrahlen mittels eines Gitter-Interferometer erzeugt wird und wobei der Eingangsstrahl zur Auswahl des jeweils zu beleuchtenden Substratoberflächenbereichs mittels einer vor dem Gitter-Interferometer angeordneten Strahlverschwenkungseinheit verschwenkt wird.

Die Erfindung bezieht sich weiter auf eine Vorrichtung zur wenigstens bereichsweise räumlich periodischen Modifikation einer in einer Probenebene anzuordnenden Oberfläche eines Substrates, umfassend
- eine Strahlverschwenkungseinheit zur Auswahl eines aktuellen Bearbeitungsbereichs durch gesteuerte Verschwenkung eines Eingangsstrahls und
- ein der Strahlverschwenkungseinheit nachgeschaltetes Gitter-Interferometer, das den Eingangsstrahl beugt und resultierende, gebeugte Teilstrahlen zur Erzeugung eines räumlich periodischen Beleuchtungsmusters in dem aktuellen Bearbeitungsbereich in der Probenebene überlagert.

### Stand der Technik

Derartige Verfahren und Vorrichtungen sind bekannt aus der DE 10 2006 032 053 A1. Verwendung finden solche Vorrichtungen und Verfahren beispielsweise im Bereich der Sicherheitstechnik, um Dokumente, Münzen, Banknoten etc. mit einem fälschungssicheren Sicherheitsmerkmal zu versehen. So führen die in die Oberflächen von Folien, Münzen, Kunststoffträgern und anderen Substraten eingebrachten Strukturen bei geeigneter Wahl des Musters zu definierten optischen Effekten, wie z.B. zu einer wellenlängen- und/oder richtungsselektiven Reflexion.

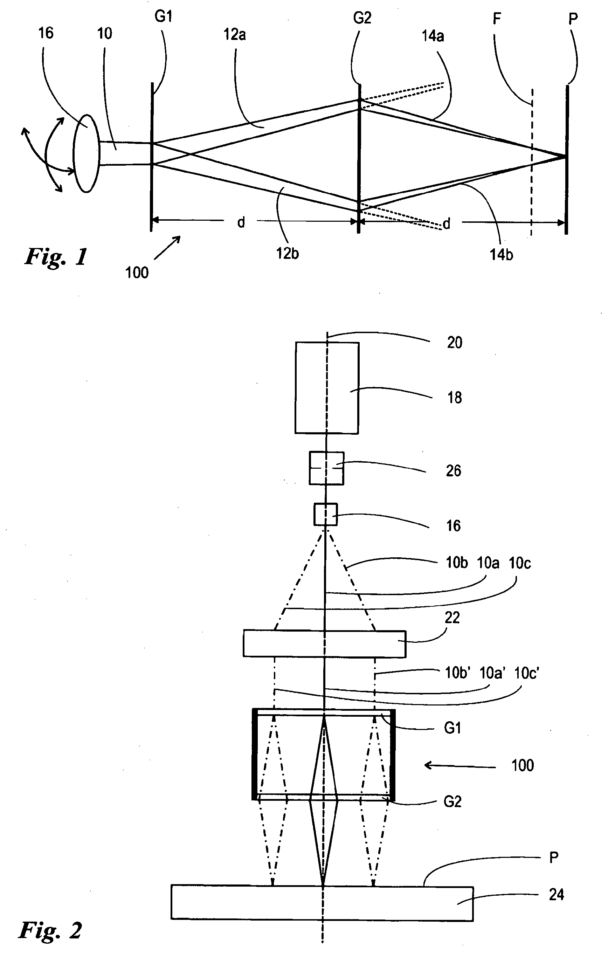

Bei dem gattungsgemäßen Verfahren bzw. der gattungsgemäßen Vorrichtung wird ein Eingangsstrahl, insbesondere ein Laserstrahl, zur Erzeugung des räumlich periodischen Beleuchtungsmusters durch ein Gitter-Interferometer geleitet. Unter einem Gitter-Interferometer sei im Rahmen dieser Anmeldung eine Vorrichtung mit wenigstens zwei parallel zueinander und im Wesentlichen senkrecht zu einer optischen Achse ausgerichteten, optischen Gittern verstanden, wobei ein Eingangsgitter geeignet eingerichtet ist, einen Eingangsstrahl durch Beugung in eine Mehrzahl von Teilstrahlen aufzuspalten, und ein Ausgangsgitter geeignet eingerichtet ist, eine Auswahl von am Eingangsgitter oder an weiteren Zwischengittern erzeugten Teilstrahlen in einer Probenebene wieder zusammenzuführen. Typischerweise ist der Abstand d zwischen jeweils zwei benachbarten Gittern gleich dem Abstand zwischen dem in Strahlrichtung letzten Gitter und einer weiter strahlabwärts angeordneten Probenebene P. Die Gitterperioden der Gitter stehen zueinander in einem besonderen Verhältnis, das die Ordnungen der sich in P interferierend überlagernden, nutzbaren Teilstrahlen bestimmt. Für die in der Praxis besonders relevante Ausführungsform des Gitter-Interferometers als Zwei-Gitter-Interferometer mit zwei Gittern G1 und G2 mit jeweiligen Gitterperioden p1 bzw. p2 gilt allgemein: Sollen die durch Beugung an G1 entstandenen Teilstrahlen der Ordnung n1 an G2 erneut gebeugt und die resultierenden Teilstrahlen der Ordnung n2 in P zur interferierenden Überlagerung gebracht werden, ist das Verhältnis der Gitterperioden p2/p1 = n2/(2*n1) zu wählen. Die Verallgemeinerung auf Gitter-Interferometer mit mehr als zwei Gittern ist dem Fachmann geläufig. In Fig. 1 ist der Strahlengang eines solchen Zwei-Gitter-Interferometers mit n1=1 und n2=2, d.h. p1=p2, dargestellt. Zur Auswahl der korrekten Teilstrahlen sind geeignete Strahlselektionsmittel, z.B. Blenden, vorgesehen, die in Fig. 1 der Übersichtlichkeit halber nicht dargestellt sind.

Ein bedeutender Vorteil des Gitter-Interferometers ist seine Eigenschaft, das Interferenzmuster unabhängig von räumlicher und zeitlicher Kohärenz, Wellenlänge und Einfallswinkel des Eingangsstrahls auszubilden. In der Praxis wird es schwer sein, die o.g. Bedingungen bzgl. Abständen und Gitterperioden vollständig, d.h. perfekt zu erfüllen; aber auch unter den in der Praxis erzielbaren Umständen gilt die vorgenannte Unabhängigkeit von Parametern des Eingangsstrahls zumindest in relevantem Maße.

Ist die Energiedichte des Beleuchtungsmusters hinreichend groß, um eine Prozessschwelle der Substratoberfläche zu überwinden, kann auf diese Weise eine entsprechende, dauerhafte Struktur in die Substratoberfläche eingebracht werden. Der Begriff der Prozessschwelle ist weit zu verstehen und umfasst beispielsweise eine Zerstörschwelle (z.B. bei Laser-Ablation) ebenso wie Energieschwellen einer thermischen oder photochemischen Reaktion.

In der Regel liegen derartige Prozessschwellen relativ hoch, sodass typischerweise eine hohe Fokussierung auf der Substratoberfläche erforderlich ist. Die zitierte, gattungsbildende Druckschrift beschäftigt sich daher insbesondere mit der Formgebung des Eingangsstrahls, sodass die Energiedichte auf der Substratoberfläche hinreichend groß zur Überwindung der Prozessschwelle, die Energiedichte im Bereich des Gitter-Interferometers jedoch hinreichend klein ist, um hier keine Zerstörung des Gitters zu provozieren. Im Ergebnis führt die starke Fokussierung dazu, dass der jeweils beleuchtete Substratoberflächenbereich, d.h. der aktuelle Bearbeitungsbereich vergleichsweise klein ist.

Um großflächige Muster zu erzeugen, wird in der genannten Druckschrift daher vorgeschlagen, vor dem Gitter-Interferometer eine Strahlverschwenkungseinheit, beispielsweise einen Spiegel-Scanner anzuordnen, der den Eingangsstrahl geeignet ablenkt, sodass das Beleuchtungsmuster in einem größeren Bereich auf der Substratoberfläche verschoben werden kann, sodass sukzessive eine großflächige Struktur in die Substratoberfläche eingebracht werden kann.

Dieser Ansatz ist jedoch limitiert, da die erreichbare Flächengröße der Gesamtstruktur stark beschränkt ist. Die Lage der Fokalebene des Eingangsstrahls, insbesondere ihr Abstand von der Probenebene, variiert mit dem Verschwenkungswinkel. Der Fokus liegt auf einem Kugelschalensegment um den Verschwenkungspunkt. Damit variiert die Abbildungsschärfe des Interferenzmusters sowie die Energiedichte, mit der die Probenoberfläche beaufschlagt wird, und somit die Bearbeitungseffizienz in Abhängigkeit vom Verschwenkungswinkel.

Aus der US 2006/0109532 A1 sind ein Verfahren und eine Vorrichtung wie oben beschrieben, jedoch ohne Strahlverschwenkungseinheit, bekannt. Zur Bearbeitung größerer Substrate werden diese auf einer bewegbaren Plattform positioniert, die nach Bearbeitung eines Teilfeldes so verschoben wird, dass ein zweites zu bearbeitendes Teilfeld an den Ort der Ausbildung des Interferenzmusters verschoben wird.

Auch die US 6,882,477 B1 offenbart eine ähnliche Vorrichtung ohne Strahlverschwenkungseinheit und mit bewegbarer Probenplattform.

Aus der US 2004/0074881 A1 sind ein Verfahren und eine Vorrichtung zum Laser-Tempern polykristalliner Halbleiterschichten bekannt. Dabei wird eine zu bearbeitende Oberfläche mit einem fokussierten Laserstrahl abgerastert. Hierzu wird ein kollimierter Strahl mittels eines galvanometrischen Spiegelscanners verschwenkt, wobei eine dem Spiegelscanner nachgeordnete F-Theta-Optik für eine Fokussierung des Strahls auf der Substratoberfläche unabhängig vom Verschwenkungswinkel sorgt.

Aus der JP 2005 066 628 A ist eine Lötvorrichtung bekannt, bei der ein verschwenkbarer Lichtstrahl durch eine Projektionsmaske auf eine zu lötende Substratoberfläche geleitet wird. Vor der Projektionsmaske durchläuft der Lichtstrahl eine F-Theta-Optik, ohne dass auf die Motivation für dieses Merkmals näher eingegangen würde.

Aus der US 2007/0138151 A1 ist eine Vorrichtung zur Laserbearbeitung einer Bearbeitungsfläche (Substratoberfläche) durch eine schlitzförmige Projektionsmaske bekannt, wobei zur Beleuchtung ein verschwenkbarer Laserstrahl, der eine telezentrische F-Theta-Optik durchläuft, Einsatz findet. Die Druckschrift erläutert ausführlich, dass durch den Einsatz der telezentrischen F-Theta-Optik ein ortsunabhängig gleichbleibender Einfallswinkel des Laserstrahls auf der Bearbeitungsfläche erreicht werden soll.

### Aufgabenstellung

Es ist die Aufgabe der vorliegenden Erfindung, ein gattungsgemäßes Verfahren und eine gattungsgemäße Vorrichtung derart weiterzubilden, dass die Schaffung großflächiger Muster ermöglicht wird.

### Darlegung der Erfindung

Diese Aufgabe wird in Verbindung mit den Merkmalen des Oberbegriffs von Anspruch 1 dadurch gelöst, dass der Eingangsstrahl zwischen der Strahlverschwenkungseinheit und dem Gitter-Interferometer eine telezentrische F-Theta-Optik durchläuft.

Die Aufgabe wird weiter in Verbindung mit den Merkmalen des Oberbegriffs von Anspruch 7 durch eine zwischen der Strahlverschwenkungseinheit und dem Gitter-Interferometer angeordnete, telezentrische F-Theta-Optik gelöst.

Bevorzugte Ausführungsformen der Erfindung sind Gegenstand der abhängigen Ansprüche.

Als F-Theta-Optiken sind Optiken bekannt, die einen kollimierten Strahl unabhängig von seinem Einfallswinkel stets in derselben Ebene fokussieren. Mit einer solchen Optik kann also sichergestellt werden, dass die Prozessschwelle der Probenoberfläche in jedem Teilbereich des Gesamtmusters in gleichem Maße überschritten, d.h. die Probenoberfläche überall gleich effizient bearbeitet werden kann.

Erfindungsgemäß ist die F-Theta-Optik als telezentrische F-Theta-Optik ausgebildet. Bei einer herkömmlichen F-Theta-Optik trifft der Eingangsstrahl außer bei Schaffung des Zentralbereichs einer großflächigen Struktur schräg auf das Gitter-Interferometer auf. Zwar ist es, wie oben erwähnt, ein besonderes Merkmal des Gitter-Interferometers, dass die Musterbildung unabhängig vom Eingangswinkel des Eingangsstrahls ist. Allerdings nimmt mit zunehmendem Eingangswinkel die Fehlertoleranz gegenüber Fehlern der Positionierung der Probe, der Relation der Gittereigenschaften sowie der Ausrichtung der einzelnen Gitter des Interferometers zueinander stark ab. Die Größe der zu schaffenden Struktur ist daher in der Praxis durch die unvermeidbare Unvollkommenheit des Gitter-Interferometers beschränkt. Telezentrische F-Theta-Optiken haben die Wirkung, einen schräg einfallenden Eingangstrahl abhängig vom Einfallswinkel zu versetzten und als parallel zur optischen Achse ausgerichteten Ausgangsstrahl auszugeben und dabei die Strahltaille eines konvergierenden Strahls unabhängig von dem Versatz bzw. Eingangswinkel in derselben Ebene zu belassen. Im Rahmen der vorliegenden Erfindung führt dies dazu, dass der Eingangsstrahl in jedem Fall senkrecht auf das Gitter-Interferometer trifft, sodass die Ausbildung des Interferenzmusters maximal fehlertolerant ist.

Günstigerweise ist die F-Theta-Optik so ausgestaltet, dass sie den Eingangsstrahl derart konvergieren lässt, dass seine gebeugten Teilstrahlen in der Nachbarschaft der Probenebene eine Strahltaille aufweisen. Die Idee der in der Nachbarschaft der Probenebene positionierten Strahltaille, die auch eine Positionierung der Strahltaille in der Probenebene einschließt, ist grundsätzlich bekannt und Gegenstand der oben bereits erwähnten DE 10 2006 032 053 A1. Durch diese Maßnahme wird erreicht, dass die Prozessschwelle des Substrates durch hinreichende Fokussierung des Beleuchtungsmusters überschritten und gleichzeitig die Gitterstruktur des Gitter-Interferometers nicht durch eine zu hohe Energiedichte dort beschädigt wird. Bei der bekannten Vorrichtung wird die Strahlformung jedoch von besonderen, der Strahlverschwenkungseinheit vorgeschalteten Strahlformungsmitteln vollzogen. Im Rahmen der vorliegenden Erfindung kann diese Aufgabe der F-Theta-Optik zugewiesen werden, die damit eine Doppelfunktion erhält.

Um den jeweiligen Bearbeitungsbereich scharf abzugrenzen kann im Strahlengang des Eingangsstrahls, vor der Strahlverschwenkungseinheit eine Blende derart angeordnet sein, dass sie in die Probenebene abgebildet wird. Besonders bevorzugt wird eine flächenfüllende Blendenform, beispielsweise ein Rechteck oder ein Sechseck gewählt, sodass die komplexe Gesamtstruktur ziegel- oder wabenförmig aus Einzelbereichen mosaikartig, flächenfüllend aufgebaut werden kann, ohne dass es zu Überlappungen oder Lücken zwischen den einzelnen Bereichen kommt.

Alternativ kann der Eingangsstrahl, insbesondere vor seinem Eintritt in die Strahlverschwenkungseinheit, auch einen sog. Flat-Top-Konverter durchlaufen, der ein Gauß-Profil des Eingangsstrahls in ein relativ scharf begrenztes, weitgehend homogenes Strahlprofil umwandelt.

Die Erfindung erlaubt es, wie oben erläutert, ein gegebenes Muster großflächiger zu gestalten. Mit anderen Worten kann die in einem Bearbeitungsbereich erzeugte Struktur gleichförmig über eine Vielzahl angrenzender Bearbeitungsbereiche erstreckt werden. Komplexere Muster, die insbesondere für komplexe Sicherheitsmerkmale auf Dokumenten, Banknoten, Münzen etc. benötigt werden, können auf diese Weise allerdings nicht geschaffen werden. Die nachfolgend dargestellten, bevorzugten Weiterbildungen der Erfindung stellen unterschiedliche Ansätze zur Lösung dieses Problems dar.

Bei einem ersten Ansatz zur Weiterbildung des erfindungsgemäßen Verfahrens ist vorgesehen, dass das Gitter-Interferometer mittels eines Antriebs in mit der Verschwenkung des Eingangsstrahls synchronisierter Weise senkrecht zu seiner optischen Achse bewegt wird. In Bezug auf die erfindungsgemäße Vorrichtung bedeutet das, dass diese gekennzeichnet ist durch
- einen Antrieb, mittels dessen das Gitter-Interferometer senkrecht zu seiner optischen Achse bewegbar ist, und
- eine Synchronisationseinheit, mittels derer die Verschwenkung des Eingangsstrahls und die Bewegung des Gitter-Interferometers synchronisiert ansteuerbar sind.

Grundgedanke dieser Weiterbildung, die grundsätzlich auch als eigenständige Erfindung, d.h. ohne eine dem Gitter-Interferometer vorgeschaltete F-Theta-Optik realisierbar ist, ist es, das Gitter-Interferometer beweglich zu gestalten und mit einem Antrieb zu versehen, der mit der Verschwenkung des Eingangsstrahls synchronisiert ist. Auf diese Weise kann jeder Verschwenkungsposition, d.h. jedem aktuellen Bearbeitungsbereich auf der Substratoberfläche eine definierte Ausrichtung und/oder Positionierung des Gitter-Interferometers zugeordnet werden. Ist, wie nachfolgend anhand bevorzugter Ausführungsformen noch näher erläutert werden soll, das erzeugte Muster von der mittels des Antriebes veränderbaren Ausrichtung und/oder Positionierung des Gitter-Interferometers abhängig, können unterschiedlichen Bearbeitungsbereichen auf der Substratoberfläche unterschiedliche Beleuchtungsmuster zugeordnet werden, sodass ein definiertes Mosaik aus unterschiedlichen Teilstrukturen zu einer Gesamtstruktur aufgebaut werden kann.

Bei einer vorteilhaften Ausführungsform des erfindungsgemäßen Verfahrens ist vorgesehen, dass der Eingangsstrahl ein gepulster Strahl ist, dessen Pulsfolge mit der Verschwenkung des Eingangsstrahls und der Bewegung des Gitter-Interferometers synchronisiert ist. Im Hinblick auf die erfindungsgemäße Vorrichtung bedeutet dies, dass der Eingangsstrahl ein gepulster Strahl ist, dessen Pulsfolge mittels der Synchronisationseinheit mit der Verschwenkung des Eingangsstrahls und der Bewegung des Gitter-Interferometers synchronisierbar ist. Der Begriff der Synchronisation ist hierbei weit zu verstehen und umfasst alle Ausgestaltungen gezielt angesteuerter, zeitlicher Abhängigkeiten. Insbesondere impliziert der Begriff keine Hierarchie innerhalb der voneinander abhängigen, zeitlichen Abfolgen. Typischerweise wird jedoch der Pulsfolge des Eingangsstrahls eine besondere Bedeutung zukommen, der insbesondere die Ansteuerung der Strahlverschwenkungseinheit hierarchisch nachgeordnet ist. Dies gilt besonders, wenn der Takt eines gepulsten Lasers als Grundtakt der Synchronisation verwendet wird. Es ist jedoch auch möglich, die Pulsfolge des Eingangsstrahls gezielt mit mechanischen und/oder optischen, insbesondere elektrooptischen Shuttern aktiv zu gestalten.

Günstigerweise umfasst die Bewegung des Gitter-Interferometers eine Rotation um dessen optische Achse oder um eine dazu parallele Achse. Im Hinblick auf die erfindungsgemäße Vorrichtung bedeutet dies, dass der Antrieb bevorzugt eine Rotationseinheit umfasst, mittels derer das Gitter-Interferometer um seine optische Achse oder eine dazu parallele Achse rotierbar ist. Alternativ oder zusätzlich kann vorgesehen sein, dass die Bewegung des Gitter-Interferometers eine Translation senkrecht zu dessen optischer Achse umfasst. Im Hinblick auf die erfindungsgemäße Vorrichtung bedeutet dies, dass der Antrieb eine Translationseinheit umfasst, mittels derer das Gitter-Interferometer senkrecht zu seiner optischen Achse verschiebbar ist.

Insbesondere im Zusammenhang mit der vorgenannten Rotierbarkeit des Gitter-Interferometers ist bevorzugt vorgesehen, dass das Gitter-Interferometer eine nicht-rotationssymmetrische Gitterstruktur aufweist. Rein beispielhaft sei ein Gitter-Interferometer mit Liniengittern aufeinander abgestimmter Periodizität als Beispiel eines nicht-rotationssymmetrischen Gitters genannt. Ein solches Gitter-Interferometer erzeugt ein Linienmuster als Beleuchtungsmuster auf der Substratoberfläche. Eine Rotation des Gitter-Interferometers um seine optische oder eine dazu parallele Achse führt zu einer entsprechenden Rotation der Linien des Beleuchtungsmusters. Durch Rotation des Gitter-Interferometers um einen Rotationswinkel, der kein ganzzahliges Vielfaches von 180 Grad ist, lassen sich somit Beleuchtungsmuster erzeugen, die sich in der Ausrichtung ihrer Linien unterscheiden. Durch eine Synchronisation der Rotation des Gitter-Interferometers, der Verschwenkung des Eingangsstrahls und ggf. der Pulsfolge des Eingangsstrahls lässt sich so auf der Substratoberfläche eine komplexe Struktur aufbauen, die sich aus Bereichen mit unterschiedlicher Linienausrichtung zusammensetzt. Die Übertragung dieses speziellen Beispiels auf jede andere Art nicht-rotationssymmetrischer Gitterstrukturen, wie z.B. Kreuzgitter, ist für den Fachmann problemlos möglich.

Bei einer anderen Ausführungsform der vorliegenden Erfindung weist das Gitter-Interferometer eine Mehrzahl von benachbarten Bereichen unterschiedlicher Gitterstruktur auf. Beispielsweise kann vorgesehen sein, dass die Bereiche unterschiedlicher Gitterstruktur in Form von Kreissektoren, die gemeinsam einen Vollkreis bilden können, angeordnet sind. Diese Variante bietet sich insbesondere in Verbindung mit einer Rotierbarkeit des Gitter-Interferometers an. Beispielsweise können die unterschiedlichen Sektoren Gitterstrukturen in Form von Linien- und/oder Kreuzgittern unterschiedlicher Periodizität aufweisen. So kann durch geeignete Rotation des Gitter-Interferometers die gewünschte Musterform und/oder Musterperiodizität für einen ausgewählten Oberflächenbereich des Substrates eingestellt werden. Zusätzlich kann durch eine geringfügige Rotation, die nicht über eine Sektorgrenze hinausgeht, die Winkelausrichtung des Beleuchtungsmusters eingestellt werden. Natürlich können die benachbarten Bereiche unterschiedlicher Gitterstruktur des Gitter-Interferometers auch in anderer Weise relativ zueinander angeordnet sein. Beispielsweise kann eine lineare Reihe von zwei oder mehr Bereichen unterschiedlicher Gitterstruktur realisiert sein. Diese Variante bietet sich insbesondere in Verbindung mit einer Translationsbewegung des Gitter-Interferometers an.

Zur Erzielung möglichst kurzer Prozesszeiten, d.h. möglichst kurzer Zeiten, die erforderlich sind, um die gewünschten, komplexen Strukturen auf der Substratoberfläche aufzubauen, ist eine für den jeweiligen Einzelfall optimierte Ansteuerung der miteinander wechselwirkenden Komponenten der Erfindung erforderlich. Dabei sind die in der Praxis gegebenen Limitierungen der einzelnen Komponenten zu beachten. So ist in der Regel der Pulstakt des Eingangsstrahles aufgrund der Bauart des jeweils verwendeten Lasers weitestgehend vorgegeben, wobei lediglich einzelne Pulse mittels eines sogenannten Pulspickers ausgelassen werden können. Die Strahlverschwenkungseinheit, die z.B. als Spiegel-Scanner, insbesondere als Mikrospiegel-Scanner ausgebildet sein kann, wird in der Regel das am schnellsten ansteuerbare Teil der Vorrichtung sein. Mikrospiegel-Scanner, die im Kilohertz-Bereich und schneller angesteuert werden können, sind dem Fachmann bekannt. Im Gegensatz dazu wird der Antrieb des Gitter-Interferometers schon aufgrund der Massenträgheit des Gitter-Interferometers selbst eher langsam bewegbar sein. Bei Ausführungsformen mit rotierbarem Gitter-Interferometer ist eine Ansteuerung möglich, bei der das Gitter-Interferometer mit konstanter und im Vergleich zu der für die Strukturausbildung erforderlichen Belichtungszeit, langsamer Geschwindigkeit rotiert. Die jeweilige Winkelstellung ist der Synchronisationseinheit bekannt. Beispielsweise wird sie kontinuierlich durch Sensoren gemessen. Die Synchronisationseinheit bestimmt hieraus das resultierende Beleuchtungsmuster und steuert die Strahlverschwenkungseinheit so an, dass ein Substratoberflächenbereich beleuchtet wird, dem innerhalb der komplexen Gesamtstruktur eine Teilstruktur mit dem gerade aktuell bestimmten Muster zugewiesen ist. Dies hat bevorzugt im Grundtakt der Eingangsstrahlpulse zu erfolgen. Diese Art der Ansteuerung wird jedoch in der Regel auf solche Anwendungen beschränkt sein, bei denen ein einzelner Puls zur Strukturausbildung in der Substratoberfläche genügt.

Häufig wird es jedoch erforderlich sein, einen Bearbeitungsbereich der Substratoberfläche mit mehreren Beleuchtungspulsen zu strukturieren. Zwischen den einzelnen Pulsen darf keine Veränderung der relativen Lage des Gitter-Interferometers zur Probe erfolgen. Bereits geringfügige Variationen, die beispielsweise durch Schwingungen des Systems eingebracht werden können, können das resultierende Beleuchtungsmuster in einer Weise verändern, die geeignet ist, die beabsichtigte Struktur zu zerstören oder zumindest zu verwaschen. Bei einer Weiterbildung der Erfindung ist daher vorgesehen, dass die Probenebene durch einen mit einem ersten Gleitblock starr verbundenen Probenträger vorgegeben ist und das Gitterinterferometer starr mit einem zweiten Gleitblock verbunden ist, wobei eine Gleitfläche des zweiten Gleitblocks auf einer korrespondierenden Gleitfläche des ersten Gleitblocks gelagert ist, sodass der zweite Gleitblock mittels des Antriebs gleitend auf dem ersten Gleitblock bewegbar ist, und wobei der zweite Gleitblock relativ zu dem ersten Gleitblock mit einer Anpresakraft beaufschlagbar ist, die ausreicht, eine Relativbewegung der Gleitblöcke zu unterbinden. Durch die Einbettung des Gitter-Interferometers in den zweiten Gleitblock wird die starre Ausrichtung und Positionierung der einzelnen Gitter des Gitter-Interferometers zueinander sichergestellt. Andererseits wird die schwingungsfreie Lagerung der Probe durch deren starre Anbindung an den ersten Gleitblock sichergestellt. Der erste Gleitblock ist bevorzugt an einer festen Basis, z.B. einem schweren Maschinenfundament, festgelegt. Die Bewegung des zweiten Gleitblocks mit dem Gitter-Interferometer ist insofern unkritisch, als dieser zweite Gleitblock jeweils zum Zeitpunkt der Oberflächenbearbeitung, d.h. zum Zeitpunkt der Beleuchtungspulse, mit seiner Gleitfläche fest auf die korrespondierende Gleitfläche des ersten Gleitblocks gepresst ist, wodurch er kraftschlüssig starr mit diesem verbunden ist. Lediglich zu Zeiten, in denen keine Oberflächenbearbeitung, d.h. keine Beleuchtung stattfindet, wird durch Lösen der Anpresskraft eine Relativbewegung, die nicht nur die beabsichtigte Rotation und/oder Translation des Gitter-Interferometers sondern beispielsweise auch unerwünschte Schwingungen umfassen kann, ermöglicht. Die Wahl einer Gleitlagerung ohne zwischengeordnete Lagerelemente, wie etwa bei einem Wälzlager, hat den Vorteil der hoch präzisen Reproduzierbarkeit der Relativpositionierung der beiden Gleitblöcke bei jedem neuen Anpressen.

Die Anpresskraft kann auf unterschiedliche Weise erzeugt werden. Beispielsweise kann vorgesehen sein, dass die Gleitblöcke mit korrespondierenden Elementen einer elektromagnetischen Anpressvorrichtung ausgestattet sind. Beispielsweise können in die Gleitblöcke korrespondierende Spulen oder eine Spule und ein ferromagnetischer Kern eingebettet sind, die auf einfache Weise elektrisch ansteuerbar sind. Alternativ kann vorgesehen sein, dass der zweite Gleitblock mit einem Aktuator einer elektromotorischen, einer hydraulischen oder einer pneumatischen Anpressvorrichtung gekoppelt ist.

Die Ausbildung der Gleitflächen, beispielsweise als polierte Glas- oder Steinflächen, die ggf. einen flüssigen oder gasförmigen Gleitfilm zwischen sich einschließen, ist für den Fachmann ohne weiteres realisierbar.

wie bereits mehrfach erwähnt, ist die präzise Ausrichtung der einzelnen Gitter innerhalb des Gitter-Interferometers von entscheidender Bedeutung. Im Rahmen der vorliegenden Erfindung müssen daher alle von dem Gitter-Interferometer umfassten Einzelgitter vollkommen gleichmäßig bewegt werden. Dies ist mit einer Einzellagerung der Gitter praktisch nicht zu erreichen. Bei einer besonders vorteilhaften Weiterbildung der erfindungsgemäßen Vorrichtung ist daher vorgesehen, dass das Gitter-Interferometer zwei parallel zueinander angeordnete Transmissionsgitter umfasst, die jeweils an einer Stirnseite eines hohlen Abstandhalteelementes stoffschlüssig starr mit diesem verbunden sind. Beispielsweise kann ein Hohlzylinder oder ein würfel- oder ein quaderförmiger, starrer Rahmen verwendet werden, an dessen Stirnseiten die Transmissionsgitter angelegt und justiert werden. In ihrer korrekten Lage können die Gitter dann mit einem schrumpfungsfrei aushärtenden Kitt oder Zement stoffschlüssig an dem Rahmen festgelegt werden. Das resultierende,

einstückige Gitter-Interferometer ist sehr robust und kann als Ganzes in eine motorisch bewegbaren Halterung der erfindungsgemäßen Vorrichtung eingesetzt werden. Auch ein Austausch ist ohne weiteres möglich. Dies ist im Hinblick auf die industrielle Anwendung der Erfindung, bei der mit einer einzigen Produktionsanlage eine Vielzahl von Strukturmustern gefertigt werden sollen, vorteilhaft. Die Vorrichtungskomponenten Laser, Strahlverschwenkungseinheit, Antrieb, Probenhalterung und Synchronisationseinheit können musterunabhängig beibehalten werden. Lediglich die typischerweise in Software realisierte Programmierung der Synchronisationseinheit und ggf. das, wie oben geschildert, leicht austauschbare Gitter-Interferometer müssen zur Herstellung neuer Strukturmuster ausgewechselt werden.

Bei einem zweiten Ansatz zur Weiterbildung des erfindungsgemäßen Verfahrens ist vorgesehen, dass das Gitter-Interferometer
- ein erstes, eingangsseitiges Gitter, das Gitterperiodizitäten in wenigstens zwei Richtungen aufweist, und
- ein zweites, ausgangsseitiges Gitter, das eine Mehrzahl von Paaren von Teilgittern paarweise gleicher und zu je einer Gitterperiodizität des ersten Gitters paralleler Gitterperiodizität aufweist, wobei die Teilgitter jedes Paares diametral beabstandet angeordnet sind und ihre jeweilige Gitterperiodizität parallel zu ihrer Abstandslinie ausgerichtet ist,
umfasst,
wobei eine dem ersten Gitter des Gitter-Interferometers nachgeschaltete, variierbare Blendenanordnung zur Auswahl von zur Überlagerung in der Probenebene vorgesehenen, gebeugten Teilstrahlen in mit der Verschwenkung des Eingangsstrahls synchronisierter Weise variiert wird.

In Bezug auf die erfindungsgemäße Vorrichtung bedeutet das, dass das Gitter-Interferometer
- ein erstes, eingangsseitiges Gitter, das Gitterperiodizitäten in wenigstens zwei Richtungen aufweist, und
- ein zweites, ausgangsseitiges Gitter, das eine Mehrzahl von Paaren von Teilgittern paarweise gleicher und zu je einer Gitterperiodizitäten des ersten Gitters paralleler Gitterperiodizität aufweist, wobei die Teilgitter jedes Paares diametral beabstandet angeordnet sind und ihre jeweilige Gitterperiodizität parallel zu ihrer Abstandslinie ausgerichtet ist,
umfasst,
wobei dem ersten Gitter des Gitter-Interferometers eine, variierbare Blendenanordnung nachgeschaltet ist, mit der zur Überlagerung in der Probenebene vorgesehene, gebeugte Teilstrahlen auswählbar sind.

Grundgedanke dieser Weiterbildung, die grundsätzlich auch als eigenständige Erfindung, d.h. ohne eine dem Gitter-Interferometer vorgeschaltete F-Theta-Optik realisierbar ist, ist es, das Gitter-Interferometer selbst festzuhalten, es jedoch so auszugestalten, dass jeweils eine Mehrzahl von gebeugten Teilstrahlpaaren erzeugt werden, die sich grundsätzlich in der Probenebene interferierend überlagern können, von denen jedoch mittels einer variablen Blendenanordnung nur dasjenige Paar ausgewählt wird, das geeignet ist, im aktuellen Bearbeitungsbereich die gewünschte Struktur zu erzeugen. Der auf das erste, eingangsseitige Gitter auftreffende Eingangsstrahl wird an diesem in unterschiedlich ausgerichtete Beugungsfächer aufgespalten. Insbesondere erzeugt jede Gitterperiodizität ihren eigenen Beugungsfächer, bestehend aus gebeugten Teilstrahlen unterschiedlicher Beugungsordnungen. Eine besonders einfache Ausführungsform eines Gitters mit mehreren, unterschiedlich ausgerichteten Gitterperiodizitäten ist ein Kreuzgitter, bestehend aus zwei senkrecht zueinander angeordneten Liniengittern. Ein solches Gitter weist drei Gitterperiodizitäten auf, nämlich die Periodizität des ersten Liniengitters, die 90° hierzu verdrehte Periodizität des zweiten Liniengitters sowie zwei gegeneinander um 90° und zu den beiden vorgenannten Gitterperiodizitäten jeweils um 45° verdrehte, zusätzliche Gitterperiodizitäten. Ein solches Kreuzgitter erzeugt vier Beugungsfächer, von denen nachfolgend der Einfachheit halber lediglich die jeweils ersten Beugungsordnungen betrachtet werden sollen, weshalb nachfolgend nur noch von Teilstrahlpaaren gesprochen werden soll. Dem Fachmann ist bekannt, wie Gitter zu fertigen sind, bei denen alle Ordnungen außer einer gewünschten Ordnung effektiv unterdrückt werden. Fallen die aufgespaltenen Teilstrahlpaare jeweils beim zweiten Gitter des Gitter-Interferometers auf Liniengitter, die in der vorgenannten weise auf die Gitterperiodizitäten des ersten Gitters des Gitter-Interferometers abgestimmt sind, überlagern sich die resultierenden Ausgangsstrahlen des Gitter-Interferometers interferierend im aktuellen Bearbeitungsbereich. Um nun genau dasjenige Teilstrahlpaar auszuwählen, welches das gewünschte Interferenzmuster erzeugt, ist eine variable Blendenanordnung vorgesehen. Diese muss zwingend hinter dem ersten Gitter des Gitter-Interferometers angeordnet sein, was ihre Anordnung vor oder hinter dem zweiten Gitter des Gitter-Interferometers einschließt. Die letztere Variante wird der einfacheren Bauweise wegen bevorzugt. Wie bereits erwähnt, erfolgt die Erläuterung des Prinzips anhand eines "Teilstrahlpaares" lediglich der Vereinfachung des Verständnisses halber. Der Fachmann wird erkennen, dass auch die Überlagerung von mehr als nur zwei Teilstrahlen zur Erzeugung des Interferenzmusters möglich ist. Die jeweils gewünschte Auswahl der zu überlagernden Teilstrahlen kann durch die entsprechende Gestaltung der der Blendenanordnung realisiert werden. In diesem Sinne sind auch die nachfolgenden Erläuterungen auszulegen.

Die spezielle Ausgestaltung der Blendenanordnung kann auf unterschiedliche Weise erfolgen. Beispielsweise kann vorgesehen sein, dass die variable Blendenanordnung als eine rotierbare, bereichsweise mit Fenstern versehene Scheibe ausgestaltet ist. Je nach Rotationswinkel der Scheibe werden unerwünschte Strahlenpaare ausgeblendet. Lediglich die gewünschten Strahlenpaare gelangen durch die Fenster zur Überlagerung in der Probenebene.

Alternativ kann vorgesehen sein, dass die variable Blendenanordnung als ein ansteuerbarer, elektro- oder magneto-optischer Transmissionsfilter ausgestattet ist, dessen Transmissionsgrad flächenbereichsweise durch entsprechende elektrische Ansteuerung variiert wird bzw. variierbar ist. Beispielsweise kann hierzu eine freiprogrammierbare Flüssigkristall-Maske verwendet werden.

Günstigerweise ist der Eingangsstrahl ein gepulster Strahl dessen Pulsfolge, insbesondere mittels der Synchronisationseinheit, mit der Verschwenkung des Eingangsstrahls und der Variation der Blendenanordnung synchronisiert ist.

Ein derartiges Gitter-Interferometer, d.h. ein Gitter-Interferometer, umfassend ein erstes, eingangsseitiges Gitter, das Gitterperiodizitäten in wenigstens zwei Richtungen aufweist und im Wesentlichen senkrecht zu einer optischen Achse angeordnet ist, und ein zweites, ausgangsseitiges Gitter, das parallel zu dem ersten Gitter angeordnet ist, wobei das zweite Gitter eine Mehrzahl von Paaren von Teilgittern paarweise gleicher und zu je einer Gitterperiodizität des ersten Gitters paralleler Gitterperiodizität aufweist, wobei die Teilgitter jedes Paares spiegelsymmetrisch von der optischen Achse beabstandet angeordnet und senkrecht zu ihrer Abstandslinie ausgerichtet sind, ist isoliert auch in anderen technischen Kontexten mit und ohne variierbare Blendenanordnung in deren unterschiedlichen Ausprägungen einsetzbar.

Bei einem dritten Ansatz zur Weiterbildung des erfindungsgemäßen Verfahrens ist vorgesehen, dass das Gitter-Interferometer wenigstens ein frei programmierbares Gitter aufweist, dessen Gitterstruktur in mit der Verschwenkung des Eingangsstrahls synchronisierter Weise angesteuert wird. In Bezug auf die erfindungsgemäße Vorrichtung bedeutet das, dass das Gitter-Interferometer wenigstens ein frei programmierbares Gitter aufweist, dessen Gitterstruktur mittels Ansteuerung durch eine Gitterstruktur-Steuereinheit variierbar ist, und weiter dass eine Synchronisationseinheit vorgesehen ist, mittels derer die Verschwenkung des Eingangsstrahls und die Variation der Gitterstruktur des wenigstens einen Gitters synchronisiert ansteuerbar sind.

Grundgedanke dieser Weiterbildung, die grundsätzlich auch als eigenständige Erfindung, d.h. ohne eine dem Gitter-Interferometer vorgeschaltete F-Theta-Optik realisierbar ist, ist es, das Gitter-Interferometer in sich veränderbar zu gestalten, sodass auf jegliche mechanische Bewegbarkeit verzichtet werden kann. Hierzu wird jeglichen Schwingungen im System entgegengewirkt, die das Beleuchtungsmuster bzw. die in die Substratoberfläche einzubringende Struktur stören, insbesondere verwaschen könnten.

Grundsätzlich ist es hinreichend, nur ein Gitter des Gitter-Interferometers auf diese weise variabel zu gestalten. Günstiger ist es jedoch, alle Gitter des Gitter-Interferometers variabel zu gestalten, sodass die realisierbare Mustervielfalt besonders groß ist.

Günstigerweise ist das freiprogrammierbare Gitter als ein im Wesentlichen transparentes, flächiges Element ausgestaltet, dessen Transparenz und/oder dessen Brechungsindex durch elektrische Ansteuerung pixelweise variiert wird bzw. im Hinblick auf die entsprechende Vorrichtung pixelweise variierbar ist. Derartige Elemente sind dem Fachmann in Form von pixelweise ansteuerbaren Flüssigkristall-Elementen bekannt, die vorzugsweise im Rahmen der Erfindung eingesetzt werden. Derartige Elemente sind typischerweise als Fenster in einem die Ansteuerelektronik enthaltenden Rahmen, der auch elektrische Anschlüsse aufweist, realisiert. Die an sich transparenten Fenster enthalten eine Flüssigkristallschicht, mittels derer einzelne Flächenpunkte des Fensters bei geeigneter elektrischer Ansteuerung ihre Eigenschaften bzgl. Transparenz und/oder bzgl. ihres Brechungsindexes ändern können. Auf diese Weise können nahezu beliebig gestaltete Phasen- oder Amplitudengitter realisiert werden.

Alternativ zu derartigen transmissiven Gittern kann das Gitterinterferometer auch durch frei programmierbare, reflektive Gitter realisiert sein. Insbesondere kann bei einer Ausführungsform der Erfindung vorgesehen sein, dass das freiprogrammierbare Gitter als ein im Wesentlichen reflektierendes, flächiges Element ausgestaltet ist, dessen Reflektivität durch elektrische Ansteuerung pixelweise variierbar ist. Derartige reflektierende, flächige Elemente sind dem Fachmann beispielsweise als pixelweise ansteuerbare Kippspiegel-Arrays bekannt.

Unabhängig von der speziellen Ausgestaltung des freiprogrammierbaren Gitters kann die elektrische Ansteuerung und damit die Variation des Gitters sehr schnell erfolgen, sodass sie zur Synchronisation mit der Strahlverschwenkungseinheit sehr gut geeignet ist. Bei einer Weiterbildung der Erfindung ist darüber hinaus vorgesehen, dass der Eingangsstrahl ein gepulster Strahl ist, dessen Pulsfolge insbesondere mittels der Synchronisationseinheit mit der Verschwenkung des Eingangsstrahls und der Variation der Gitterstruktur synchronisiert ist.

Weitere Merkmale und Vorteile der vorliegenden Erfindung ergeben sich aus der nachfolgenden, speziellen Beschreibung und den Zeichnungen.

### Kurzbeschreibung der Zeichnungen

Es zeigen:
- Figur 1:: eine schematische Darstellung einer Vorrichtung nach dem Stand der Technik,
- Figur 2:: eine schematische Darstellung einer erfindungsgemäßen Weiterentwicklung mit der Vorrichtung von Figur 1,
- Figur 3:: eine schematische Darstellung einer Ausführungsform eines Zwei-Gitter-Interferometers,
- Figur 4:: eine schematische Darstellung einer alternativen Ausführungsform eines Zwei-Gitter-Interferometers,
- Figur 5:: eine schematische Darstellung einer komplexen Oberflächenstruktur,
- Figur 6:: eine schematische Darstellung einer erfindungsgemäßen Vorrichtung zur Schaffung einer Struktur gemäß 5,
- Figur 7:: eine schematische Darstellung einer Ausführungsform einer vorteilhaften Gitterstruktur,
- Figur 8:: eine schematische Darstellung einer mechanischen Realisierung der Vorrichtung von Figur 6,
- Figur 9:: eine schematische Darstellung einer vorteilhaften Gitterstruktur zur Schaffung der Oberflächenstruktur von Figur 5,
- Figur 10:: eine schematische Darstellung des Funktionsprinzips einer Vorrichtung unter Verwendung eines Gitters gemäß Figur 9,
- Figur 11:: eine schematische Darstellung eines freiprogrammierbaren Gitters.

### Ausführliche Beschreibung bevorzugter Ausführungsformen

Figur 1 ist eine schematische Darstellung einer Zwei-Gitter-Anordnung gemäß dem Stand der Technik, die zur direkten Durchführung einer prozessschwellenabhängigen Oberflächenmodifikation zur Strukturierung einer Substratoberfläche geeignet ist. Der Klarheit der Darstellung halber sind Teilstrahlen nicht genutzter Ordnungen sowie Blenden zu deren Ausblenden und ähnliche Hilfsmittel nicht oder nur gestrichelt dargestellt.

Ein Eingangsstrahl 10, fällt auf ein von den Gittern G1 und G2 gebildetes Zwei-Gitter-Interferometer 100. Die Einzelgitter G1 und G2 sind als Liniengitter mit einer Gitterausrichtung senkrecht zur zeichnungsebene ausgebildet, wobei die Periode des ersten Gitters G1 doppelt so groß ist wie die Periode des zweiten Gitters G2. Sie sind in einem Abstand d planparallel zueinander ausgerichtet. Der Eingangsstrahl 10 wird am ersten Gitter G1 in mehrere Beugungsordnungen aufgespalten, von denen in Figur 1 jeweils die ersten Ordnungen 12a und 12b dargestellt sind. Teilstrahlen niedrigerer und höherer Ordnungen sind in Figur 1 nicht dargestellt. Am zweiten Gitter G2 erfahren die Teilstrahlen 12a, 12b eine erneute Beugung, wobei insbesondere Teilstrahlen 14a und 14b der erneut ersten Ordnungen zur Bildung eines Interferenzmusters in der Probenebene P überlagert werden. Diese grundsätzliche Wirkungsweise eines Gitter-Interferometers ist dem Fachmann bekannt. Auch die Verallgemeinerung auf Mehr-Gitter-Interferometer und/oder andere Gitterstrukturen und/oder unterschiedliche Gitterperiodizitäten der Einzelgitter ist dem Fachmann bekannt. All solche Varianten sollen auch von der vorliegenden Erfindung umfasst sein.

Der Eingangsstrahl 10 ist bei der in Figur 1 dargestellten Ausführungsform des Standes der Technik mittels eines Scanners 16 verschwenkbar, sodass durch sukzessive Beleuchtung benachbarter Bereiche der Substratoberfläche in der Probenebene P eine großflächige, einheitliche Struktur erzeugt werden kann.

Bei der in Figur 1 dargestellten Ausführungsform des Standes der Technik ist der Eingangsstrahl ein konvergierender Strahl, der mittels nicht dargestellter Strahlformungsmittel so geformt ist, dass die sich zur Bildung des Beleuchtungsmusters in der Probenebene P überlagernden Teilstrahlen 14a, b in einer der Probenebene P benachbarten Fokalebene F eine Strahltaille aufweisen. Bei anderen Ausführungsformen kann die Fokalebene F auch hinter oder in der Probenebene P liegen. Das Merkmal der zu der Probenebene P benachbarten Fokalebene F ist auch Gegenstand einer bevorzugten Ausführungsform der vorliegenden Erfindung, wobei diese jedoch grundsätzlich auch mit nicht-konvergierendem Eingangsstrahl 10, insbesondere mit kollimiertem Eingangsstrahl 10 arbeiten könnte.

Figur 2 zeigt eine schematische Darstellung einer erfindungsgemäßen Vorrichtung zur direkten Durchführung einer prozessschwellenabhängigen Oberflächenmodifikation zur Strukturierung einer Substratoberfläche. Ein von einer Lichtquelle 18, die bevorzugt als Laser und insbesondere als gepulster Laser ausgebildet ist, erzeugter Eingangstrahl 10 durchläuft einen Scanner 16, der beispielsweise als ansteuerbarer Spiegel-Scanner ausgebildet ist, jedoch auch in anderer Form realisiert sein kann.

In Figur 2 sind außer dem durchgezogen dargestellten Zentralstrahl 10a, der der gestrichelt dargestellten optischen Achse 20 folgt, strichpunktiert auch zwei Strahlwege 10b, 10c dargestellt, denen der Eingangsstrahl 10 bei verschwenkter Stellung des Scanners 16 folgt.

Der Eingangsstrahl durchläuft gemäß der Erfindung eine telezentrische F-Theta-Optik 22, die unabhängig vom Eingangswinkel senkrechte Ausgangsstrahlen 10a', 10b', 10c' ausgibt, die jeweils' parallel zur optischen Achse verlaufen und deren Abstand von der optischen Achse vom Verschwenkungswinkel des Scanners 16 vorzugsweise linear abhängt. Die Strahlen 10a', 10b', 10c' bilden die senkrecht auf das Gitter-Interferometer 100 fallenden Eingangsstrahlen, die in der bekannten Weise gebeugt und zur Bildung des Beleuchtungsmusters in der Probenebene P auf der Oberfläche des Substrates 24 wiedervereinigt werden.

Der Übersichtlichkeit der Darstellung von Figur 2 halber ist die Strahlformung, insbesondere die Konvergenz und Strahltaillen nicht dargestellt. Bevorzugt ist die F-Theta-Optik jedoch so ausgestaltet, dass die Strahlen eine Strahltaille in der Nähe oder in der Probenebene P aufweisen.

In Figur 2 ist im Strahlengang rein schematisch noch eine Blendenanordnung 26 eingezeichnet, die dazu dient, den jeweils aktuellen Bearbeitungsbereich, d.h. den jeweils von dem Beleuchtungsmuster zu einem Zeitpunkt ausgeleuchteten Bereich der Probenebene P, scharf zu begrenzen. Die Blendenanordnung 26 ist so in den Strahlengang zu integrieren, dass die die Begrenzung des Bearbeitungsbereichs definierende Blende in die Probenebene P abgebildet wird. Alternativ zur Blendenanordnung 26 können auch andere Strahlformungsmittel, wie beispielsweise ein sogenannter Flat-Top-Konverter zur scharfen Begrenzung des Bearbeitungsbereiches verwendet werden. Grundsätzlich ist es selbstverständlich auch möglich, auf derartige Strahlformungsmittel vollständig zu verzichten.

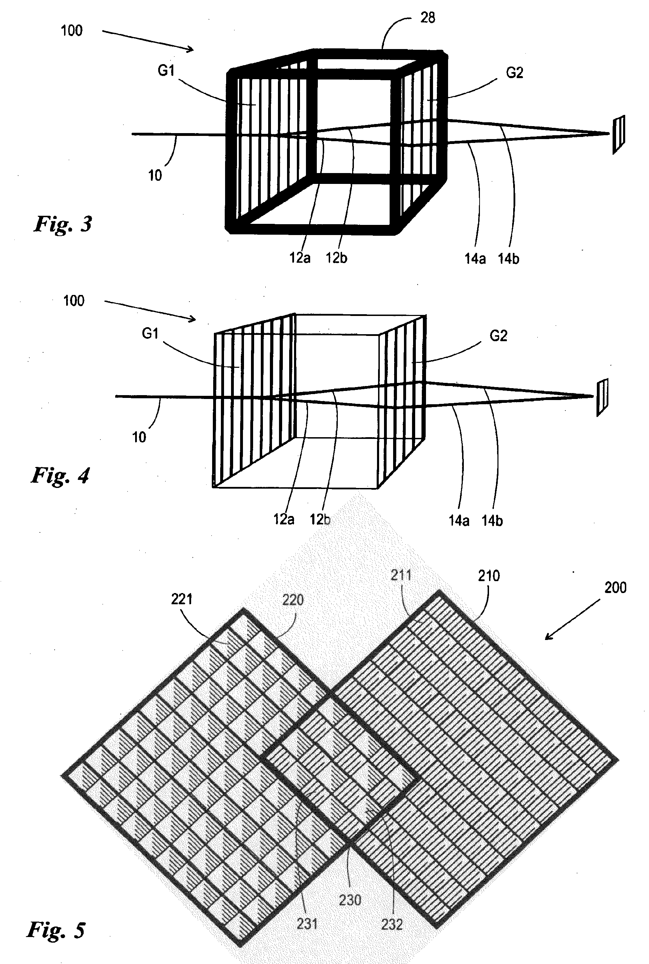

Um ein scharfes Interferenzmuster in der Probenebene erzeugen zu können, ist die Qualität des Gitter-Interferometers 100 von besonderer Bedeutung. Insbesondere müssen die das Gitter-Interferometer 100 aufbauenden Gitter sehr präzise zueinander justiert sein und dürfen sich während des Bearbeitungsvorganges keinesfalls relativ zueinander bewegen. Eine Einzelaufhängung und Einzeljustage der Gitter ist daher nicht optimal. Die Figuren 3 und 4 zeigen unterschiedliche Ausführungsformen eines Zwei-Gitter-Interferometers 100, die dieses Problem lösen. Bei der ersten Ausführungsform gemäß Figur 3 ist ein starrer Rahmen 28 vorgesehen, der bei der gezeigten Ausführungsform entlang der Kanten eines Würfels verläuft. Der Rahmen kann beispielsweise aus massiven Metallstreben, die stoffschlüssig miteinander verbunden sind, ausgebildet sein. Die Gitter G1 und G2 erstrecken sich auf einander gegenüberliegenden Flächen des Würfels und sind an ihren Rändern mit dem Rahmen 28 starr verbunden. Zur Fertigung eines derartigen Gitter-Interferometers werden die Gitter G1 und G2 vorzugsweise zunächst am Rahmen 28 zueinander justiert und dann mit einem schrumpfungsfrei aushärtenden Kitt mit dem Rahmen 28 verbunden. Dabei ist es möglich, Justage-Hilfsvorrichtungen, die beispielsweise Stellschrauben, die sich am Rahmen 28 abstützen, nach erfolgter Justage mit einzukitten. Nach dem Aushärten des Kitts ist ein derartiges Gitter-Interferometer sehr robust und kann auf einfache Weise schnell bewegt und/oder ausgetauscht werden, ohne dass eine Neujustage erforderlich wäre.

Die Ausführungsform des Zwei-Gitter-Interferometers 100 gemäß Figur 4 geht von einem transparenten monolithischen Block 30 aus. Wenigstens zwei einander gegenüberliegende Flächen des monolithischen Blocks 30 müssen mit äußerster Präzision parallel zueinander gefertigt und poliert sein. In diese Präzisionsflächen können alsdann Gitterstrukturen eingebracht werden, beispielsweise durch mechanisches Ritzen, durch Laserablation, durch nasschemisches Ätzen oder auf andere Weise. Bei dieser Ausführungsform ist eine nachträgliche Justage nicht möglich; vielmehr muss der gesamte Fertigungsprozess mit äußerster Präzision erfolgen. Das resultierende Gitter-Interferometer 100 ist jedoch ebenso robust und leicht bewegbar bzw. austauschbar wie das Gitter-Interferometer gemäß Figur 3.

Eine erfindungsgemäße Vorrichtung, wie bisher beschrieben, ist, wie im Rahmen der allgemeinen Beschreibung ausführlich erläutert, geeignet, große Bearbeitungsflächen zu strukturieren, indem jeweils kleine Bearbeitungsbereiche nacheinander strukturiert werden. Neben der reinen Größe der Bearbeitungsfläche ist auch die Erhöhung der Komplexität der erreichbaren Musterung ein insbesondere in der Sicherheitstechnik relevantes Ziel.

Figur 5 zeigt in stark schematisierter Darstellung ein Muster 200, welches sich aus zwei jeweils quadratischen Teilmustern 210, 220, die einander in einem Überlappungsbereich 230 überlappen, zusammensetzt. Die Quadrate 210, 220 sind jeweils aus einzelnen Bearbeitungsbereichen 211, 221 zusammengesetzt, die eine in der oben geschilderten Weise erzeugte Linienstruktur aufweisen. Die Linienausrichtung der Bearbeitungsbereiche 211, 221 ist unterschiedlich. Man beachte, dass die in Figur 5 gezeigten Grenzlinien zwischen den Bearbeitungsbereichen 211 bzw. 221 je eines Quadrates 210 bzw. 220 nur der Veranschaulichung der Bearbeitungsbereiche und deren mosaikartiger Zusammensetzung dienen. Die tatsächlich erzeugte Struktur wird in der Regel keine derartigen Grenzlinien aufweisen; vielmehr sollen die Quadrate 210, 220 jeweils durchgehend schraffiert erscheinen.

Bei geeigneter Wahl der Linienabstände können sich schraffurabhängig unterschiedliche optische Effekte, insbesondere unterschiedliche Reflexionseigenschaften ergeben, sodass beispielsweise unter verschiedenen Blickwinkeln jeweils nur eines der Quadrate 210, 220 sichtbar ist. Im Überlappungsbereich 230 der Quadrate 210, 220 wechseln sich Bearbeitungsbereiche 231, 232 unterschiedlicher Musterausrichtung ab. Typische Abmessungen für ein derartiges Muster sind Linienabstände von 1 bis 1,5 Mikrometer und "Pixelgrößen", d.h. laterale Ausdehnungen der einzelnen Bearbeitungsbereiche 211, 221 bzw. 231, 232 von ca. 50 Mikrometern oder, bevorzugt, darunter. Diese Wahl der "Pixelgröße" ist dem Auflösungsvermögen des menschlichen Auges geschuldet. Insbesondere werden solche Muster bevorzugt, deren "Pixel" vom menschlichen Auge gerade nicht mehr aufgelöst werden können. Auf diese Weise erscheinen nämlich Überlappungsbereiche, wie etwa der Überlappungsbereich 230 nicht mehr "gerastert"; vielmehr erscheint unter jedem Blickwinkel das jeweils sichtbare Teilmuster 210, 220 kontinuierlich. Sind andere optische Effekte gewünscht, können die vorgenannten Größenparameter selbstverständlich auch anders gewählt werden.

Zur Schaffung eines Musters, wie dasjenige von Figur 5 ist es erforderlich, für jeden Bearbeitungsbereich 211, 221 bzw. 231, 232 ein speziell gewünschtes Beleuchtungsmuster anzusteuern. Dies ist auf unterschiedlichen Weisen möglich von denen nachfolgend drei besonders vorteilhafte mit den zugehörigen Vorrichtungen beschrieben werden sollen.

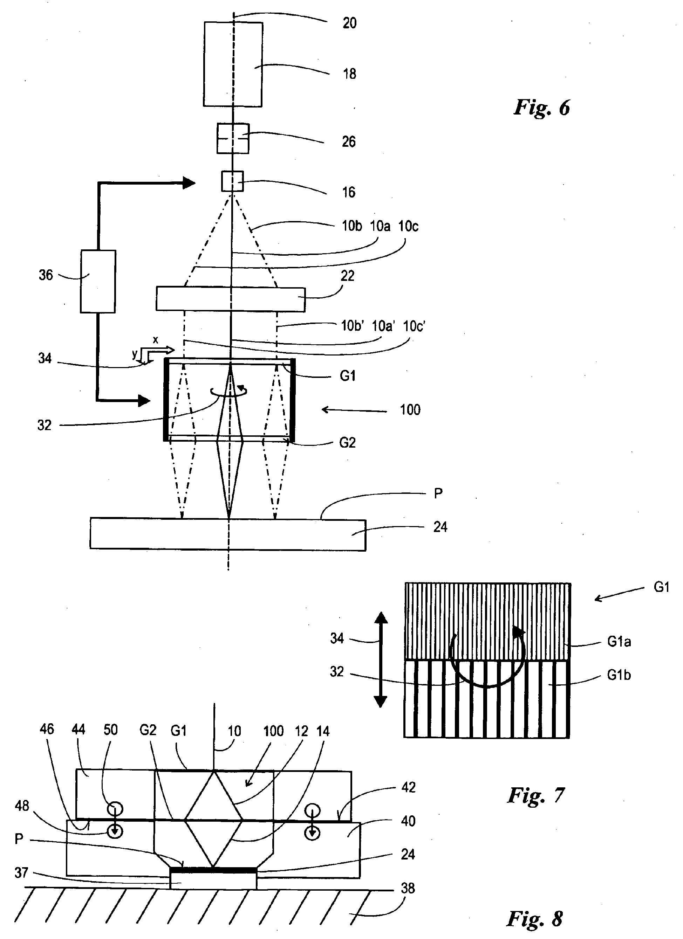

Die Figuren 6 bis 8 betreffen eine erste Ausführungsform der erfindungsgemäßen Vorrichtung, wobei das Gitter-Interferometer 100 motorisch bewegt wird und zwar in mit dem Scanner 16 synchronisierter Weise. Dies ist in Figur 6, die im Übrigen der Figur 2 entspricht, angedeutet durch einen Rotationspfeil 32 und einen Translationspfeil 34, die die Bewegbarkeit des Gitter-Interferometer 100 andeuten, sowie durch die Synchronisationseinheit 36, die den Antrieb des Gitter-Interferometers 100 und die Ansteuerung des Scanners 16 synchronisiert.

Die Synchronisationseinheit wird typischerweise computerbasiert sein. Die spezielle Zuordnung von Verschwenkungswinkel, d.h. Auswahl eines Bearbeitungsbereiches, und Musterwahl, d.h. Orientierung bzw. Positionierung des Gitter-Interferometers 100, werden typischerweise in Software hinterlegt.

Figur 7 zeigt eine einfache Ausführungsform eines Zweibereichs-Gitters zur Verwendung in einem Gitter-Interferometer 100 gemäß Figur 6. Beispielhaft ist das in Figur 7 gezeigte Gitter als erstes Gitter G1 bezeichnet. Dieses Gitter G1 umfasst zwei Teilbereiche G1a und G1b, die als parallele Liniengitter unterschiedlicher Periodizität ausgebildet sind. Der Fachmann wird leicht erkennen, dass eine Rotation des das Gitter G1 enthaltenen Gitter-Interferometers 100 gemäß dem Rotationspfeil 32 zu einer Änderung der Orientierung der Gitterlinien und somit zu einer Änderung der Orientierung des Beleuchtungsmusters führt. Weitergehend Rotation, insbesondere Rotation um ca. 180°, führt für einen gegebenen Bearbeitungsbereich zu einer Änderung der Periodizität des Gitters, d.h. zu einer Änderung der Periodizität des Beleuchtungsmusters. Letzteres kann anstatt durch erhebliche Rotation auch durch Translation des Gitter-Interferometers gemäß dem Translationspfeil 34 erreicht werden.

Häufig wird die Einbringung der Struktur in die Substratoberfläche nicht durch einen einzigen Beleuchtungspuls erzielbar sein. Vielmehr werden in der Regel mehrere Beleuchtungspulse nötig sein. Dabei ist es erforderlich, dass sich das Beleuchtungsmuster zwischen den Pulsen nicht ändert, um eine Verwaschung der Strukturen zu vermeiden. Dies wird jedenfalls die Regel sein, wobei Ausnahmen, bei denen ein einzelner Bearbeitungsbereich gezielt nacheinander mit unterschiedlichen Mustern beleuchtet wird, selbstverständlich nicht ausgeschlossen sind. Um zwischen den einzelnen Pulsen das Beleuchtungsmuster stabil zu halten, ist eine besonders stabile Lagerung des Gitter-Interferometers 100 relativ zur Probenebene P erforderlich. Dies wird naturgemäß durch die Bewegbarkeit des Gitter-Interferometers 100 erschwert.

Figur 8 zeigt eine vorteilhafte Ausführungsform, die dieses Problem löst. Ein Probenträger 37 ist auf einem stabilen Fundament 38 festgelegt. Das zu bearbeitende Substrat 24 ist auf dem Probenträger 37 angeordnet. Der Probenträger 37 ist fest mit einem schweren Gleitblock 40 gekoppelt. Die Masse des Geleitblocks 40 und seine Kopplung mit dem Probenträger 36 sollten vom Fachmann so dimensioniert sein, dass typische, bei der Bearbeitung auftretende Schwingungen unterbunden werden. Auf der Gleitfläche 42 des Gleitblocks 40 ist ein weiterer Gleitblock 44 mit seiner Gleitfläche 46 gelagert. Der zweite Gleitblock 44 ist starr mit dem Gitter-Interferometer 100 verbunden. Auch der zweite Gleitblock 44 ist bevorzugt schwer ausgestaltet, sodass Vibrationen unterbunden werden. Ein in Figur 8 nicht dargestellter Antrieb ist mit dem zweiten Gleitblock 44 gekoppelt, sodass dieser auf der Gleitfläche 42 gleitend bewegt werden kann.

Während der eigentlichen Strukturierung, d.h. zum Zeitpunkt der Beleuchtung der Substratoberfläche mit einem Beleuchtungspuls, soll der zweite Gleitblock 44 jedoch relativ zum ersten Gleitblock 40 fixiert sein. Hierzu ist in den ersten Gleitblock 40 die Spule 48 eines Elektromagneten und in den Gleitblock 44 ein ferromagnetischer Kern 50 eingebettet. Beschickung der Spule 48 mit Strom führt zu einem Anziehen des zweiten Gleitblocks 44 auf den ersten Gleitblock 40 und so zu einer reproduzierbaren Fixierung des Gitter-Interferometers 100 relativ zum Substrat 24 und insbesondere zur Probenebene P. In dieser Position können beliebig viele Pulse zur Strukturierung des aktuell ausgewählten Bearbeitungsbereichs abgegeben werden. Anschließend können in der gleichen Position des Gitter-Interferometers weitere Bearbeitungsbereiche, in denen dasselbe Strukturmuster realisiert werden soll, nacheinander bearbeitet werden. Danach kann die Spule 48 abgeschaltet, das Gitter-Interferometer 100 mittels seines Antriebs gleitend verstellt werden und nach erneuter Fixierung durch Bestromung der Spule 48 weitere Bearbeitungsbereiche mit dem neuen Beleuchtungsmuster beleuchtet werden.

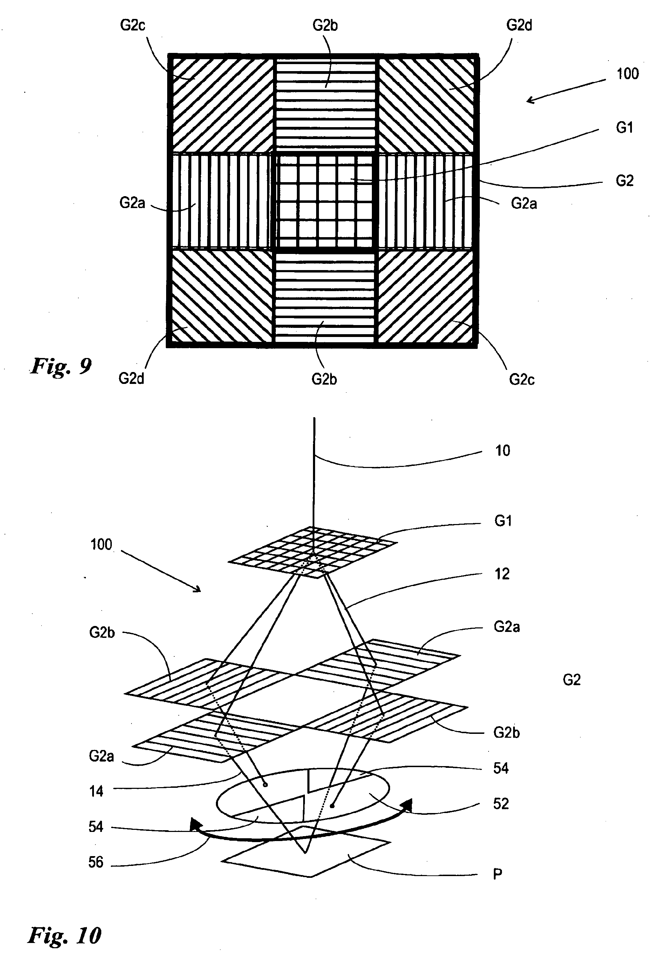

Die Figuren 9 und 10 zeigen schematisch eine zweite Variante zur Schaffung komplexer Muster. Insbesondere zeigen die Figuren 9 und 10 jeweils ein Gitter-Interferometer 100, welches anstelle des in Figur 2 gezeigten Gitter-Interferometers 100 in die dort gezeigte Grundform der erfindungsgemäßen Vorrichtung eingesetzt werden kann. Das hier beschriebene, besondere Gitter-Interferometer 100 umfasst ein eingangsseitiges Gitter G1, welches vier Gitterperiodizitäten aufweist. Insbesondere ist das Gitter G1 als senkrechtes Kreuzgitter ausgestaltet, welches sich als Überlagerung zweier senkrecht zueinander ausgerichteter Liniengitter gleicher Periodizität denken lässt. Die resultierenden Periodizitäten sind die Grundperiodizitäten der beiden Liniengitter sowie die hierzu jeweils diagonalen Periodizitäten. Das ausgangsseitige Gitter G2 umfasst acht Teilgitter, die in vier jeweils diametral beabstandete Gitterpaare G2a, G2b, G2c, G2d gruppiert sind. Die Teilgitter des Gitters G2 sind jeweils als Liniengitter ausgebildet. Jedes Gitterpaar G2a, G2b, G2c, G2d weist zwei Gitter mit identischer Gitterstruktur auf. Die Periodizitäten jedes Gitterpaares G2a, G2b, G2c, G2d erstrecken sind jeweils in Richtung einer der Periodizitäten des eingangsseitigen Gitters G1. Die Gitterpaare des Gitters G2 sind lateral zum Gitter G1 so angeordnet, dass ihre Gitterperiodizitäten die jeweils korrespondierende Periodizität des Gitters G1 lateral fortsetzen.

Das Funktionsprinzip eines derartigen Gitter-Interferometers 100 ist in Figur 10 verdeutlicht, wobei der Anschaulichkeit halber von dem zweiten Gitter G2 nur die beiden Gitterpaare G2a und G2b dargestellt sind. Ein Eingangsstrahl 10, der auf das eingangsseitige Gitter G1 fällt, wird an jeder Gitterperiodizität des Gitters G1 in einen Beugungsfächer aufgespalten, von dem in Figur 10 jeweils nur die Teilstrahlen 12 erster Ordnung gezeigt sind. Bei geeigneter Gestaltung des Gitters G1 lassen sich die Beugungsfächer auch tatsächlich auf Teilstrahlen einer gewünschten Ordnung reduzieren. Jeder der Teilstrahlen 12 fällt gemäß seinem Beugungswinkel auf ein Teilgitter des ausgangsseitigen Gitters G2 um dort erneut gebeugt zu werden. Die an den korrespondierenden Teilgittern je eines Gitterpaares G2a, G2b gebeugten Teilstrahlen werden in der Probenebene P interferierend überlagert.

Um nun genau diejenigen Teilstrahlen auszuwählen, die zu dem im aktuellen Bearbeitungsbereich gewünschten Beleuchtungsmuster führen, ist zusätzlich eine rotierbare Blendenscheibe 52 mit transparenten Fensterbereichen 54 hinter dem ausgangsseitigen Gitter G2 angeordnet. Je nach Winkeleinstellung der Blendenscheibe 52 werden bestimmte gebeugte Teilstrahlpaare 14 durchgelassen und können in der Probenebene P das gewünschte Muster erzeugen, während andere Teilstrahlpaare 14 von der Blendenscheibe 52 ausgeblendet werden. Die Bewegung der Blendenscheibe 52 erfolgt synchronisiert zu der Bewegung des Scanners 16. Insbesondere kann bei einer gegebenen Einstellung der Blendenscheibe 52 der Scanner alle Bearbeitungsbereiche, die das durchgelassene Beleuchtungsmuster benötigen, nacheinander abarbeiten. Danach wird die Blendenscheibe 52 so verstellt, dass ein anderes Muster erzeugende Teilstrahlen durchgelassen werden. Der Scanner arbeitet dann alle für dieses Muster vorgesehene Bearbeitungsbereiche ab und so weiter. Die Rotierbarkeit der Blendenscheibe 52 ist durch den Rotationspfeil 56 dargestellt. Alternativ zu der rotierbaren Blendenscheibe 52 können auch andere Blendengestaltungen, z.B. frei programmierbare optische Filter verwendet werden.

Der Vorteil dieser Variante gegenüber der zuvor geschilderten Variante mit motorisch bewegbarem Gitter-Interferometer ist, dass das im Hinblick auf die Justage empfindliche Gitter-Interferometer 100 festgehalten und insbesondere starr in eine Vorrichtung eingebaut werden kann. Auf dieser Weise ist die starre Verbindung zum Substrat zu jedem Verfahrenszeitpunkt gegeben. Lediglich ein für die grundsätzliche Funktion des Gitter-interferometers 100 nicht relevantes Bauteil, nämlich die Blendenscheibe 52 muss mechanisch bewegbar sein. Dieser Vorteil wird jedoch mit dem Nachteil einer geringeren Variabilität der erzeugbaren Muster erkauft.

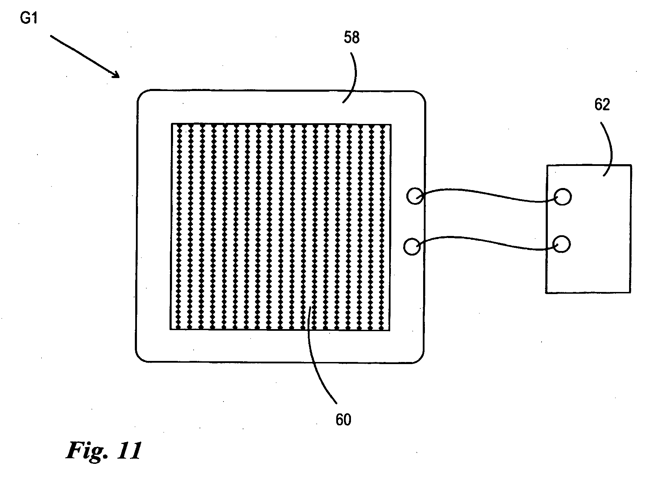

Figur 11 schließlich zeigt eine dritte Variante zur Erzeugung unterschiedlicher Muster in unterschiedlichen Bearbeitungsbereichen. Dargestellt ist ein beispielhaft als erstes Gitter G1 bezeichnetes freiprogrammierbares Gitter, welches ein Gitter eines nicht im weiteren Detail dargestellten Gitter-Interferometers darstellt. Bei dem gezeigten Gitter G1 handelt es sich um ein in einem Rahmen 58 angeordnetes Fenster 60, welches zwischen zwei Schutzscheiben eine Flüssigkristall-Schicht enthält, die durch im Rahmen 58 angeordnete Elektroden, die von einer Steuereinheit 62 mit elektrischer Spannung beaufschlagbar sind, pixelweise angesteuert werden kann. Dies bedeutet, dass je nach Kombination der spannungsbeaufschlagten Elektroden ein entsprechender Bereich des Fensters seine Transparenz und/oder seinen Brechungsindex ändert. Derartige Flüssigkristall-Elemente sind dem Fachmann bekannt. Mit ihnen lassen sich quasi beliebig geformte Gitterstrukturen erzeugen. Mit mehreren derartigen, hintereinander aufgebauten Gittern lassen sich bei entsprechend abgestimmter Programmierung Gitter-Interferometer im Sinne der vorliegenden Erfindung realisieren, deren resultierendes Beleuchtungsmuster sehr schnell verändert werden kann. Die Veränderung hat in synchronisierter Weise mit der Verschwenkung des Eingangsstrahl, d.h. mit der Steuerung des Scanners 16 zu erfolgen. Man beachte, dass die Rasterung der Gitterlinien in Figur 11 nur der Veranschaulichung der pixelweisen Ansteuerbarkeit des Gitters dienen.

### Bezugszeichenliste

- 10: Eingangsstrahl
- 10a, b, c,: verschwenkter Eingangsstrahl
- 10a', b', c': verschwenkter Eingangsstrahl
- 12a, b,: gebeugter Teilstrahl
- 14a, b: gebeugter Teilstrahl
- 16: Scanner
- 18: Laser
- 20: optische Achse
- 22: F-Theta-Optik
- 24: Substrat
- 26: Blendenanordnung
- 28: Rahmen
- 30: monolithischer Block
- 32: Rotationspfeil
- 34: Translationsteil
- 36: Synchronisationseinheit
- 37: Probenträger
- 38: Fundament
- 40: erster Gleitblock
- 42: Gleitfläche von 40
- 44: zweiter Gleitblock
- 46: Gleitfläche von 44
- 48: Spule
- 50: ferromagnetischer Kern
- 52: Blendenscheibe
- 54: Fenster in 52
- 56: Rotationspfeil
- 58: Rahmen
- 60: Fenster
- 62: Steuereinheit
- 100: Gitter-Interferometer
- 200: Muster
- 210: Teilmuster
- 211: Bearbeitungsbereich von 210
- 220: Teilmuster
- 221: Bearbeitungsbereich von 220
- 230: Überlappungsbereich
- 321: Bearbeitungsbereich von 230
- 232: Bearbeitungsbereich von 230
- G1: eingangsseitiges Gitter
- G2: ausgangsseitiges Gitter
- P: Probenebene
- d: Abstand zwischen G1, G2; G2, P
- F: Fokalebene

## Patentansprüche

1. Verfahren zur wenigstens bereichsweise räumlich periodischen Modifikation einer in einer Probenebene (P) angeordneten Oberfläche eines Substrates (24), indem unterschiedliche Bereiche (211, 221, 231, 232) der Substratoberfläche nacheinander jeweils mit einem räumlich periodischen Beleuchtungsmuster einer Energiedichte oberhalb einer Prozessschwelle der Substratoberfläche beaufschlagt werden,
wobei das Beleuchtungsmuster mittels Beugung eines Eingangsstrahls (10) und Überlagerung resultierender, gebeugter Teilstrahlen (12, 14) mittels eines Gitter-Interferometers (100) erzeugt wird und
wobei der Eingangsstrahl (10) zur Auswahl des jeweils zu beleuchtenden Substratoberflächenbereichs (211, 221, 231, 232) mittels einer vor dem Gitter-Interferometer (100) angeordneten Strahlverschwenkungseinheit (16) verschwenkt wird,
**dadurch gekennzeichnet,**
**dass** der Eingangsstrahl (10) zwischen der Strahlverschwenkungseinheit (16) und dem Gitter-Interferometer (100) eine telezentrische F-Theta-Optik (22) durchläuft.

2. Verfahren nach Anspruch 1,
**dadurch gekennzeichnet,**
**dass** das Gitter-Interferometer (100) mittels eines Antriebs in mit der Verschwenkung des Eingangsstrahls (10) synchronisierter Weise senkrecht zu seiner optischen Achse (20) bewegt, insbesondere rotiert und/oder verschoben wird.

3. Verfahren nach Anspruch 2,
**dadurch gekennzeichnet,**
**dass** der Eingangsstrahl (10) ein gepulster Strahl ist, dessen Pulsfolge mit der Verschwenkung des Eingangsstrahls (10) und der Bewegung des Gitter-Interferometers (100) synchronisiert ist.

4. Verfahren nach einem der Ansprüche 2 bis 3,
**dadurch gekennzeichnet,**
**dass** das wenigstens ein Gitter (G1; G2) des Gitter-Interferometers (100) eine nicht-rotationssymmetrische Gitterstruktur und/oder eine Mehrzahl von benachbarten Bereichen (G1a, G1b; G2a, G2b, G2c, G2d) unterschiedlicher Gitterstruktur aufweist.

5. Verfahren nach Anspruch 1,
**dadurch gekennzeichnet,**
**dass** das Gitter-Interferometer (100)
- ein erstes, eingangsseitiges Gitter (G1), das Gitterperiodizitäten in wenigstens zwei Richtungen aufweist, und
- ein zweites, ausgangsseitiges Gitter (G2), das eine Mehrzahl von Paaren von Teilgittern (G2a, G2b, G2c, G2d) paarweise gleicher und zu je einer Gitterperiodizität des ersten Gitters (G1) paralleler Gitterperiodizität aufweist, wobei die Teilgitter jedes Paares (G2a, G2b, G2c, G2d) diametral beabstandet angeordnet sind und ihre jeweilige Gitterperiodizität parallel zu ihrer Abstandslinie ausgerichtet ist,
umfasst,
wobei eine dem ersten Gitter (G1) des Gitter-Interferometers (100) nachgeschaltete, variierbare Blendenanordnung (52, 54) zur Auswahl von zur Überlagerung in der Probenebene (P) vorgesehenen, gebeugten Teilstrahlen (12, 14) in mit der Verschwenkung des Eingangsstrahls (10) synchronisierter Weise variiert wird.

6. Verfahren nach Anspruch 5,
**dadurch gekennzeichnet,**
**dass** der Eingangsstrahl (10) ein gepulster Strahl ist, dessen Pulsfolge mit der Verschwenkung des Eingangsstrahls (10) und der Variation der Blendenanordnung (52, 54) synchronisiert ist.

7. Vorrichtung zur wenigstens bereichsweise räumlich periodischen Modifikation einer in einer Probenebene (P) anzuordnenden Oberfläche eines Substrates (24), umfassend
- eine Strahlverschwenkungseinheit (16) zur Auswahl eines aktuellen Bearbeitungsbereichs (211, 221, 231, 232) durch gesteuerte Verschwenkung eines Eingangsstrahls (10) und
- ein der Strahlverschwenkungseinheit (16) nachgeschaltetes Gitter-Interferometer (100), das den Eingangsstrahl (10) beugt und resultierende, gebeugte Teilstrahlen (12a, b; 14a, b) zur Erzeugung eines räumlich periodischen Beleuchtungsmusters in dem aktuellen Bearbeitungsbereich (211, 221, 231, 232) in der Probenebene (P) überlagert,
**gekennzeichnet durch**
eine zwischen der Strahlverschwenkungseinheit (16) und dem Gitter-Interferometer (100) angeordnete, telezentrische F-Theta-Optik (22).

8. Vorrichtung nach Anspruch 7,
**gekennzeichnet durch**
- einen Antrieb, mittels dessen das Gitter-Interferometer (100) senkrecht zu seiner optischen Achse (20) bewegbar, insbesondere rotierbar und/oder verschiebbar ist, und
- eine Synchronisationseinheit (36), mittels derer die Verschwenkung des Eingangsstrahls (10) und die Bewegung des Gitter-Interferometers (100) synchronisiert ansteuerbar sind.

9. Vorrichtung nach Anspruch 8,
**dadurch gekennzeichnet,**
**dass** der Eingangsstrahl (10) ein gepulster Strahl ist, dessen Pulsfolge mittels der Synchronisationseinheit (36) mit der Verschwenkung des Eingangsstrahls (10) und der Bewegung des Gitter-Interferometers synchronisiert ist.

10. Vorrichtung nach einem der Ansprüche 8 bis 9,
**dadurch gekennzeichnet,**
**dass** wenigstens ein Gitter (G1) des Gitter-Interferometers (100) eine nicht-rotationssymmetrische Gitterstruktur und/oder eine Mehrzahl von benachbarten Bereichen (G1a, G1b) unterschiedlicher Gitterstruktur aufweist.

11. Vorrichtung nach einem der Ansprüche 8 bis 10,
**dadurch gekennzeichnet,**
**dass** die Probenebene (P) durch einen mit einem ersten Gleitblock (40) starr verbundenen Probenträger (37) vorgegeben ist und das Gitter-Interferometer (100) starr mit einem zweiten Gleitblock (44) verbunden ist, wobei eine Gleitfläche (46) des zweiten Gleitblocks (44) auf einer korrespondierenden Gleitfläche (42) des ersten Gleitblocks (42) gelagert ist, sodass der zweite Gleitblock (44) mittels des Antriebs gleitend auf dem ersten Gleitblock (40) bewegbar ist, und
wobei der zweite Gleitblock (44) relativ zu dem ersten Gleitblock (40) mit einer Anpresskraft beaufschlagbar ist, die ausreicht, eine Relativbewegung der Gleitblöcke (40, 44) zu unterbinden.

12. Vorrichtung nach Anspruch 7,
**dadurch gekennzeichnet,**
**dass** das Gitter-Interferometer (11)
- ein erstes, eingangsseitiges Gitter (G1), das Gitterperiodizitäten in wenigstens zwei Richtungen aufweist, und
- ein zweites, ausgangsseitiges Gitter (G2), das eine Mehrzahl von Paaren von Teilgittern (G2a, G2b, G2c, G2d) paarweise gleicher und zu je einer Gitterperiodizität des ersten Gitters (G1) paralleler Gitterperiodizität aufweist, wobei die Teilgitter jedes Paares (G2a, G2b, G2c, G2d) diametral beabstandet angeordnet sind und ihre jeweilige Gitterperiodizität parallel zu ihrer Abstandslinie ausgerichtet ist,
umfasst,
wobei dem ersten Gitter des Gitter-Interferometers eine, variierbare Blendenanordnung nachgeschaltet ist, mit der zur Überlagerung in der Probenebene vorgesehene, gebeugte Teilstrahlen auswählbar sind und
wobei weiter eine Synchronisationseinheit (36) vorgesehen ist, mittels derer die Verschwenkung des Eingangsstrahls (10) und die Variation der Blendenanordnung (52, 54) zur Auswahl der Teilstrahlen (12, 14) synchronisiert ansteuerbar sind.

13. Vorrichtung nach Anspruch 12,
**dadurch gekennzeichnet,**
**dass** der Eingangsstrahl (10) ein gepulster Strahl ist, dessen Pulsfolge mittels der Synchronisationseinheit (36) mit der Verschwenkung des Eingangsstrahls (10) und der Variation der Blendenanordnung (52, 54) synchronisiert ist.

## Claims

1. Method for modifying in a spatially periodic manner at least in some regions a surface of a substrate (24), said surface being disposed on a sample plane (P), by acting upon different regions (211, 221, 231, 232) of the substrate surface successively with a spatially periodic illumination pattern of an energy density above a processing threshold of the substrate surface,
where the illumination pattern is generated by diffraction of an input beam (10) and superimposition of resulting, diffracted sub-beams (12, 14) by means of a grid interferometer (100), and
where, in order to select the substrate surface region to be illuminated in each case (211, 221, 231, 232), the input beam (10) is deviated by means of a beam-deviating unit (16) arranged upstream of the grid interferometer (100),
**characterised in that**
the input beam (10) passes through a telecentric F-Theta lens (22) between the beam-deviating unit (16) and the grid interferometer (100).

2. The method according to Claim 1,
**characterised in that**
the grid interferometer (100) is moved, especially rotated and/or shifted, perpendicular to its optical axis (20) by a drive in synchrony with the deviation of the input beam (10).

3. The method according to Claim 2,
**characterised in that**
the input beam (10) is a pulsed beam whose pulse sequence is synchronised with the deviation of the input beam (10) and the movement of the grid interferometer (100).

4. The method according to any of the Claims 2 to 3,
**characterised in that**
at least one grid (G1; G2) of the interferometer (100) has a non-rotationally symmetrical grid structure and/or a plurality of adjacent regions (G1a, Gib; G2a, G2b, G2c, G2d) with different grid structures.

5. The method according to Claim 1,
**characterised in that**
the grid interferometer (100) comprises
- a first, input-side grid (G1), which exhibits grid periodicities in at least two directions, and
- a second, output-side grid (G2) that exhibits a plurality of pairs of sub-grids (G2a, G2b, G2c, G2d), each pair having a grid periodicity that is identical within each pair and parallel to respectively one grid periodicity of the first grid (G1), where the sub-grids of each pair (G2a, G2b, G2c, G2d) are arranged and spaced diametrically and their respective grid periodicity is oriented parallel to their distance line
where a variable aperture arrangement (52, 54) downstream from the first grid (G1) of the grid interferometer (100) is varied synchronously with the deviation of the input beam (10), for selecting from among sub-beams (12, 14) provided for superimposition in the sample plane (P).

6. The method according to Claim 5,
**characterised in that**
the input beam (10) is a pulsed beam whose pulse sequence is synchronised with the deviation of the input beam (10) and the variation of the aperture arrangement (52, 54).

7. A device for modifying in a spatially periodic manner at least in some regions a surface of a substrate (24) to be arranged in a sample plane (P), comprising
- a beam-deviating unit (16) for selecting a current processing region (211, 221, 231, 232) by controlled deviation of an input beam (10) and
- a grid interferometer (100) arranged downstream from the beam-deviating unit (16), which interferometer diffracts the input beam (10) and superimposes in the sample plane the resulting diffracted sub-beams (12a, b; 14a, b) to create a spatially periodic illumination pattern in the current processing region (211, 221, 231, 232),
**characterised by**
a telecentric F-Theta lens (22) arranged between the beam-deviating unit (16) and the grid interferometer (100).

8. The device according to claim 7,
**characterised by**
- a drive by means of which the grid interferometer (100) can be moved, especially rotated and/or shifted, perpendicularly to its optical axis (20), and
- a synchronisation unit (36) by means of which the deviation of the input beam (10) and the movement of the grid interferometer (100) can be controlled synchronously.

9. The device according to claim 8,
**characterised in that**
the input beam (10) is a pulsed beam whose pulse sequence is synchronised by means of the synchronization unit (36) with the deviation of the input beam (10) and the movement of the grid interferometer.

10. The device according to any of Claims 8 to 9,
**characterised in that**
the at least one grid (G1) of the grid interferometer (100) has a grid structure that is non-rotationally symmetrical and/or a plurality of adjacent regions (G1a, G1b) with different grid structures.

11. The device according to any of Claims 8 to 10,
**characterised in that**
the sample plane (P) is provided in the form of a sample carrier (37) that is rigidly fixed to a first slide pad (40) and that the grid interferometer (100) is rigidly fixed to a second slide pad (44), where a slide surface (46) of the second slide pad (44) is arranged on a corresponding slide surface (42) of the first slide pad (42) such that the second slide pad (44) can be slid by means of the drive on the first slide pad (40) and where a pressing force sufficient to prevent relative movement of the slide pads (40, 44) can be applied to the second slide pad (44) relative to the first slide pad (40).

12. The device according to claim 7,
**characterised in that**
the grid interferometer (11) comprises
- a first, input-side grid (G1), which exhibits grid periodicities in at least two directions, and
- a second, output-side grid (G2) that exhibits a plurality of pairs of sub-grids (G2a, G2b, G2c, G2d), each pair having a grid periodicity that is identical within each pair and parallel to respectively one grid periodicity of the first grid (G1), where the sub-grids of each pair (G2a, G2b, G2c, G2d) are arranged and spaced diametrically and their respective grid periodicity is oriented parallel to their distance line
where a variable aperture arrangement is arranged downstream from the first grid of the grid interferometer, with which aperture arrangement one can select diffracted sub-beams to be superimposed in the sample plane and
where a second synchronization unit (36) is provided by means of which the deviation of the input beam (10) and the variation of the aperture arrangement (52, 54) can be controlled synchronously to select the sub-beams (12, 14).

13. The device according to claim 12,
**characterised in that**
the input beam (10) is a pulsed beam whose pulse sequence is synchronised by means of the synchronization unit (36) with the deviation of the input beam (10) and the variation of the aperture arrangement (52, 54).

## Revendications

1. Procédé pour la modification spatialement périodique, au moins par endroits, d'une surface d'un substrat (24) disposée dans un plan d'échantillon (P), par le fait que différentes zones (211, 221, 231, 232) de la surface du substrat sont respectivement successivement soumises à un motif d'éclairage spatialement périodique d'une densité d'énergie supérieure à un seuil de traitement de la surface du substrat,
sachant que le motif d'éclairage est produit par diffraction d'un faisceau entrant (10) et superposition des faisceaux partiels diffractés résultants (12, 14) au moyen d'un interféromètre à réseau (100),
et sachant qu'afin de sélectionner la zone respective (211, 221, 231, 232) de la surface du substrat à éclairer, le faisceau entrant (10) est pivoté au moyen d'une unité (16) de pivotement de faisceau disposée avant l'interféromètre à réseau (100),
**caractérisé en ce que**
le faisceau entrant (10) traverse, entre l'unité (16) de pivotement de faisceau et l'interféromètre à réseau (100), une optique télécentrique F-thêta (22).

2. Procédé selon la revendication 1, **caractérisé en ce que** l'interféromètre à réseau (100) est, au moyen d'un entraînement et d'une manière synchronisée avec le pivotement du faisceau entrant (10), déplacé perpendiculairement à son axe optique (20), en particulier en rotation et/ou en translation.

3. Procédé selon la revendication 2, **caractérisé en ce que** le faisceau entrant (10) est un faisceau pulsé dont la séquence d'impulsions est synchronisée avec le pivotement du faisceau entrant (10) et le déplacement de l'interféromètre à réseau (100).

4. Procédé selon l'une des revendications 2 à 3, **caractérisé en ce qu'**au moins un réseau (G1; G2) de l'interféromètre à réseau (100) présente une structure de réseau sans symétrie de révolution et/ou une pluralité de zones voisines (G1a, G1b ; G2a, G2b, G2c, G2d) ayant des structures de réseau différentes.

5. Procédé selon la revendication 1, **caractérisé en ce que** l'interféromètre à réseau (100) comprend
- un premier réseau (G1), du côté d'entrée, qui présente des périodicités de réseau dans au moins deux directions,
- et un deuxième réseau (G2), du côté de sortie, qui présente une pluralité de paires de réseaux partiels (G2a, G2b, G2c, G2d) dont la périodicité de réseau, dans chaque paire, est identique et parallèle à une périodicité de réseau respective du premier réseau (G1), sachant que les réseaux partiels (G2a, G2b, G2c, G2d) de chaque paire sont disposés en étant diamétralement distants et que leur périodicité de réseau respective est orientée parallèlement à leur ligne d'espacement,
sachant qu'afin de sélectionner les faisceaux partiels diffractés (12, 14) destinés à être superposés dans le plan d'échantillon (P), on fait varier d'une manière synchronisée avec le pivotement du faisceau entrant (10) un ensemble de diaphragme variable (52, 54) monté en aval du premier réseau (G1) de l'interféromètre à réseau (100).

6. Procédé selon la revendication 5, **caractérisé en ce que** le faisceau entrant (10) est un faisceau pulsé dont la séquence d'impulsions est synchronisée avec le pivotement du faisceau entrant (10) et la variation de l'ensemble de diaphragme (52, 54).

7. Dispositif pour la modification spatialement périodique, au moins par endroits, d'une surface d'un substrat (24) à disposer dans un plan d'échantillon (P), comprenant
- une unité (16) de pivotement de faisceau pour sélectionner une zone de traitement actuelle (211, 221, 231, 232) par pivotement commandé d'un faisceau entrant (10),
- et un interféromètre à réseau (100), monté en aval de l'unité (16) de pivotement de faisceau, qui diffracte le faisceau entrant (10) et qui superpose les faisceaux partiels diffractés résultants (12a, b ; 14a, b) dans le plan d'échantillon (P) afin de produire un motif d'éclairage spatialement périodique dans la zone de traitement actuelle (211, 221, 231, 232),
**caractérisé par** une optique télécentrique F-thêta (22), disposée entre l'unité (16) de pivotement de faisceau et l'interféromètre à réseau (100).

8. Dispositif selon la revendication 7, **caractérisé par**
- un entraînement, au moyen duquel l'interféromètre à réseau (100) peut être déplacé perpendiculairement à son axe optique (20), en particulier en rotation et/ou en translation,
- et une unité de synchronisation (36), au moyen de laquelle le pivotement du faisceau entrant (10) et le déplacement de l'interféromètre à réseau (100) peuvent être commandés d'une manière synchronisée.

9. Dispositif selon la revendication 8, **caractérisé en ce que** le faisceau entrant (10) est un faisceau pulsé dont la séquence d'impulsions, au moyen de l'unité de synchronisation (36), est synchronisée avec le pivotement du faisceau entrant (10) et le déplacement de l'interféromètre à réseau.

10. Dispositif selon l'une des revendications 8 à 9, **caractérisé en ce qu'**au moins un réseau (G1) de l'interféromètre à réseau (100) présente une structure de réseau sans symétrie de révolution et/ou une pluralité de zones voisines (G1a, G1b) ayant des structures de réseau différentes.

11. Dispositif selon l'une des revendications 8 à 10, **caractérisé en ce que** le plan d'échantillon (P) est prédéfini par un support d'échantillon (37) rigidement relié à un premier bloc de glissement (40) et l'interféromètre à réseau (100) est rigidement relié à un deuxième bloc de glissement (44), sachant qu'une surface de glissement (46) du deuxième bloc de glissement (44) est reçue sur une surface de glissement correspondante (42) du premier bloc de glissement (40), de sorte que le deuxième bloc de glissement (44) peut, au moyen de l'entraînement, être déplacé en glissement sur le premier bloc de glissement (40), et sachant que le deuxième bloc de glissement (44) peut être sollicité par rapport au premier bloc de glissement (40) avec une force de pression qui suffit à empêcher un mouvement relatif des blocs de glissement (40, 44).

12. Dispositif selon la revendication 7, **caractérisé en ce que** l'interféromètre à réseau (100) comprend
- un premier réseau (G1), du côté d'entrée, qui présente des périodicités de réseau dans au moins deux directions,
- et un deuxième réseau (G2), du côté de sortie, qui présente une pluralité de paires de réseaux partiels (G2a, G2b, G2c, G2d) dont la périodicité de réseau, dans chaque paire, est identique et parallèle à une périodicité de réseau respective du premier réseau (G1), sachant que les réseaux partiels (G2a, G2b, G2c, G2d) de chaque paire sont disposés en étant diamétralement distants et que leur périodicité de réseau respective est orientée parallèlement à leur ligne d'espacement,
sachant qu'un ensemble de diaphragme variable, qui permet de sélectionner les faisceaux partiels diffractés destinés à être superposés dans le plan d'échantillon, est monté en aval du premier réseau de l'interféromètre à réseau,
et sachant en outre qu'il est prévu une unité de synchronisation (36) au moyen de laquelle le pivotement du faisceau entrant (10) et la variation de l'ensemble de diaphragme (52, 54) peuvent être commandés d'une manière synchronisée afin de sélectionner les faisceaux partiels (12, 14).

13. Dispositif selon la revendication 12, **caractérisé en ce que** le faisceau entrant (10) est un faisceau pulsé dont la séquence d'impulsions est, au moyen de l'unité de synchronisation (36), synchronisée avec le pivotement du faisceau entrant (10) et la variation de l'ensemble de diaphragme (52, 54).
